# EUROPEAN PATENT APPLICATION

(11) **EP 1 914 886 A1**
(43) Date of publication of application: **23.04.2008**
(21) Application number: 06301062.3
(22) Date of filing: 19.10.2006
(51) Int. Cl.: H03F 1/48, H03F 1/56, H03F 1/02

(54) **Multi-band power amplifier**

(71) Applicant: Alcatel Lucent, 75008 Paris (FR)
(72) Inventor: Wiegner, Dirk, 71409 Schwaikheim (DE); Nass, Tobias, 70435 Stuttgart-Zuffenhausen (DE)
(74) Representative: Rausch, Gabriele

(57) **Abstract**

In order to improve the performances of an amplifier across a broad range of frequencies, the input matching network (16), and optionally the output matching network (36), comprise/s a plurality of individually selectable sub networks. Each sub network comprises a switching element (S1-S3) and a matching element (M1-M3) comprising preferably a capacitor. Depending on the desired operating frequency, one of the switching elements is turned ON while the other switching elements remain OFF.
To improve the efficiency, it is furthermore suggested to regulate (18) the supply voltage and/or bias voltage of the amplifying transistor (14) in response to the detected (20) envelope signal of the input signal to be amplified.

## Description

### BACKGROUND OF THE INVENTION

The present invention relates to a multi-band multi-standard power amplifier for amplifying a radio frequency (RF) signal, by provision of a new amplifier concept, which combines adaptive matching and adaptive biasing. The invention further relates to a base station for mobile communication and a transmitter comprising a multi-band multi-standard power amplifier. Furthermore the invention relates to a method for operating a multi-band multi-standard power amplifier.

Today's mobile communication systems are characterized by various different wireless communication standards, like e. g. GSM (Global System for Mobile communication), UMTS (Universal Mobile Telecommunication System) or WiMAX (Worldwide Interoperability for Microwave Access) which exist in different frequency ranges, e. g. 900 MHz, 1800 MHz, 2100 MHz, 3500 MHz, etc.. Addressing every frequency band and every standard by a separate base station leads to an exploding product portfolio for system manufacturers. Additionally, modern digital modulation schemes like W-CDMA (Wideband Code Division Multiple Access), as used by e. g. UMTS, are characterized by strongly varying signal envelopes with high peak-to-average ratios (PAR) of e. g. greater than 10.5 dB. Due to the high PAR, the amplifier has to be operated with enough back-off from its maximum operation level - often assumed as 1 dB compression point - in order to meet the high linearity requirements of new communication standards.

Since the signal peaks of amplitude modulated signals (as e.g. used in case of W-CDMA) also contain information, the power amplifier has to be operated with enough back-off in order not to cut these high signal peaks. For the lower signal levels this means that the amplifier is operated with too high back-off, which leads to an decreased efficiency in case of lower signal levels. Since the lower signal levels are dominating, the average power level is e.g. in case of WiMAX about 12 dB lower compared to the signal peaks, which leads to less than 10 % efficiency at average output power in case of e.g. WiMAX, which uses an OFDM (Orthogonal Frequency Division Multiplexing) signal, if no clipping and no linearization is used.

In DE 10 2004 017 528 A1 a power amplifier for amplifying a radio frequency signal is described. Parameters of the power amplifier can be controlled by a control unit to adapt the power amplifier to amplitude characteristics of an input signal. An output matching network matches the radio frequency signal output by the power amplifier to antenna characteristics of the antenna to which the radio frequency signal is output by the power amplifier.

In WO 00/19626 A1 a programmable mobile radiotelephone terminal is described. Matching networks of amplifiers of the mobile radiotelephone can be adapted according to frequency characteristics of signals to be amplified.

### OBJECT OF THE INVENTION

Due to an increasing number of communication bands and communication standards, the product portfolio of system manufacturers explodes. The efficiency of telecommunications equipment decreases due to complex modulation schemes, especially for multi-band equipment.

It is therefore an object of the invention to provide a power amplifier, transmitter and base station for multi-band and multi-standard use with improved efficiency.

It is also an object of the invention to provide a method for operating a multi-band multi-standard power amplifier efficiently.

### SUMMARY OF THE INVENTION

These objects, and others that appear below, are achieved by a power amplifier module according to claim 1, a corresponding transmitter according to claim 9, a corresponding base station according to claim 10 and a method according to claim 11.

According to a first aspect of the invention, the power amplifier comprises an adaptive input matching network at the input of the amplifier transistor. The input matching network is adaptable to different frequency bands depending in which frequency band the signal has currently to be transmitted. The adaptive input matching network provides the possibility to cover frequency bands distributed over a wide frequency range with good matching and high gain.

According to another embodiment of the invention, the adaptive matching of the input matching network is achieved by switches, e. g. positive intrinsic negative (PIN) diodes, and matching elements, like e.g. capacitors. This leads to an improved matching and thus improved performance of the amplifier for each of the addressed frequency bands. By the adaptive input matching network, an intended frequency band can be selected by switching on the switch within the input matching network, the switch being related to the intended frequency, while the remaining switches within the input matching network which are related to the other frequency bands are in off-mode.

According to a preferred embodiment of the invention, the adaptive input matching network comprises sub networks which are realized in a parallel manner. Each sub network may be designed to do the output matching for one frequency band. Alternatively or additionally the output matching for one frequency band may be done by one ore more sub networks. The number of sub networks used may for example depend on the number of frequency bands to which the input matching network is adaptable or may depend on the number of sub networks used per frequency band.

To match the output signal of the power amplifier to characteristics of the parts following, e. g. antenna, antenna network, circulator, feeder etc., the power amplifier comprises an output matching network. Either to reduce the required design effort or to overcome the limited power capability of the current available switching elements, a fix but wideband output matching can be chosen, as implemented in one embodiment example. In this embodiment a good input match and thus high gain due to the adaptive input matching network and a wideband power characteristic can be achieved.

The output matching network can optionally also be adaptive, depending on power capability of available switching elements and the output power level of the amplifier. In a preferred embodiment of the invention, the power amplifier comprises an adaptive output matching network. The in-and output matching networks are adaptable to the frequency bands, in which the signal has to be transmitted. The adaptive matching of the output matching network is also achieved by switches, e. g. positive intrinsic negative (PIN) diodes, and matching elements, like e.g. capacitors. In the adaptive output matching network, an intended frequency band can be selected by switching on the switch within the adaptive output matching network, the switch being related to the intended frequency, while the remaining switches within the output matching network which are related to the other frequency bands are in off-mode.

According to a preferred embodiment of the invention, the adaptive output matching network comprises sub networks which are realized in a parallel manner. Each sub network may be designed to do the output matching for one frequency band. Alternatively or additionally the output matching for one frequency band may be done by one ore more sub networks. The number of adaptive output sub netzworks is variable. It can be used only one sub network, optionally two or three or more sub networks can be used. The number of sub networks used may for example depend on the number of frequency bands to which the matching network is adaptable. The number of sub networks used may for example depend on the number of frequency bands to which the matching network is adaptable or may depend on the number of sub networks used per frequency band.

According to another preferred embodiment of the invention, the power amplifier comprises a bias control unit which is able to adapt the operating point or the 1 dB compression point of the amplifier transistor by suitably controlling drain and possibly gate voltage. By this, the control unit can for example adapt the supply voltage of the amplifier transistor. This is advantageous compared to amplifier transistors with constant supply voltage, as operation close to the 1 dB compression point of the amplifier can be achieved most of the time. This leads to increased efficiency.

When adapting the amplifier transistor, according to another embodiment of the invention, the operating point of the amplifier transistor ist adapted to an amplitude characteristic of the input signal. For example the supply voltage of the amplifier transistor is dynamically adapted to each signal level, thus the amplifier will always be operated close to the 1 dB compression point, leading to an improved efficiency. In order to feed the RF input signal to the bias control unit, which is responsible for the dynamic bias adaptation of the amplifying transistor, which leads to an increased efficiency, either a signal detection unit is placed in between the RF input port of the power amplifier and the DC (direct current) control unit, or the signal will be directly tapped from the digital part via an interface to the control unit, e. g. by tapping the In-Phase and Quadrature values (I&Q values) of the signal.

In a preferred embodiment of the invention, the bias control unit is for example a suitable high efficient modulator, providing varying supply voltages to the amplifier transistor, the supply voltages being related to each signal level detected by the signal detection unit or received by the digital part.

The invention is also realized in a transmitter comprising the inventive power amplifier. The transmitter can be used for transmission of multi-band multi-standard signals. Base stations realizing the invention comprise said transmitter. Such base stations are capable of providing multi-band multi-standard service.

The invention is also realized in operating a power amplifier as described above, comprising the steps of adapting the input matching network to the frequency band of the input signal and dynamically adapting the supply voltage of the amplifier transistor to an amplitude signal characteristic of the RF input signal.

### BRIEF DESCRIPTION OF THE DRAWINGS

Other characteristics and advantages of the invention will become apparent in the following detailed description of preferred embodiments of the invention illustrated by the accompanying drawings given by way of nonlimiting illustrations. The same reference numerals may be used in different figures of the drawings to identify the same or similar elements.
- Fig. 1: shows a schematic overview of an example of the inventive multi-band multi-standard power amplifier,
- Fig. 2: shows a schematic circuit diagram example of an adaptive input matching network and an adaptive output matching network and

- Fig. 3: shows a schematic overview of an embodiment example of an inventive multi-band/multi-standard power amplifier with adaptive input and adaptive output matching networks.

### DETAILED DESCRIPTION OF THE INVENTION

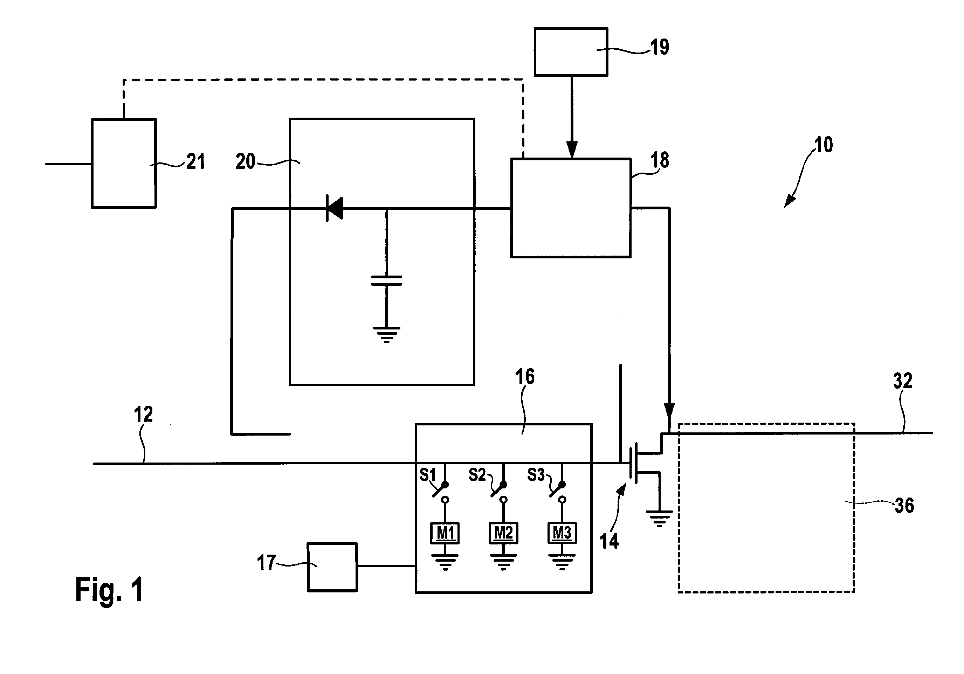

Fig.1 shows a schematic overview of an inventive multi-band multi-standard power amplifier 10 according to the present invention.

The power amplifier 10 comprises an input port 12, an amplifier transistor 14, an adaptive input matching network 16 connected to a matching control unit 17, a bias control unit 18 with a connected voltage or current source 19, either a signal detection unit 20, or a direct interface to the digital transmit part 21, an output matching network 36 and an output port 32. The output matching network 36 provides an output matching from the power transistor's 14 output to the output of the power amplifier 10.

The input matching network 16 is adaptive and provides the possibility to cover frequency bands distributed over a wide frequency range with good matching and high gain in a serial manner. The input matching network 16 comprises sub networks interconnected in a parallel manner. The first sub network comprises a first matching element M1, e.g. a capacitor C1, a first switching element S1. This first sub network is connected to the RF input matching line in a distance L1 from the power transistor's 14 input. The second sub network comprises a second matching element M2, e.g. a capacitor C2 and a second switching element S2. This second sub network is connected to the RF input matching line in a distance L2 from the power transistor's 14 input. The third sub network comprises a third matching element M3, e.g. a capacitor C3 and a third switching element S3. This third sub network is connected to the RF input matching line in a distance L3 from the power transistor's 14 input. The adaptive matching of the input matching network is achieved by switching elements S1, S2, S3, e. g. PIN diodes and matching elemets M1, M2, M3, e.g. capacitors C1, C2, C3. The control of the adaptation of the matching is done over the matching control unit 17. The matching control unit 17 is for example used to switch the switches S1, S2, S3. The first distance L1 from the transistor's 14 input is adapted to a first frequency band, to which the input matching network 16 is to be matched when the first switching element S1 is closed. The second distance L2 from the transistor's 14 input is adapted to a second frequency band, to which the input matching network 16 is to be matched when the second switching element S2 is closed. The third distance L3 from the transistor's 14 input is adapted to a third frequency band, to which the input matching network 16 is to be matched when the third switching element S3 is closed. If e.g. the first frequency band has to be covered, S1 is switched on, S2 and S3 are switched off and thus, matching element M1 is active, resulting in an improved matching for the first frequency band. If the second frequency band is addressed, S2 is switched on, matching element M2 is active and the remaining switches S1 and S3 are in off-state.

The output matching network 36 may be fix. A fix output matching network 36 is advantageous in the case of high power amplifiers, as switching components like e. g. PIN diodes don't up to now well resist high power levels. In this case a fix wideband output matching network 36 is applied. By this and the adaptive input matching network 16, a good input match and also a good gain can still be achieved.

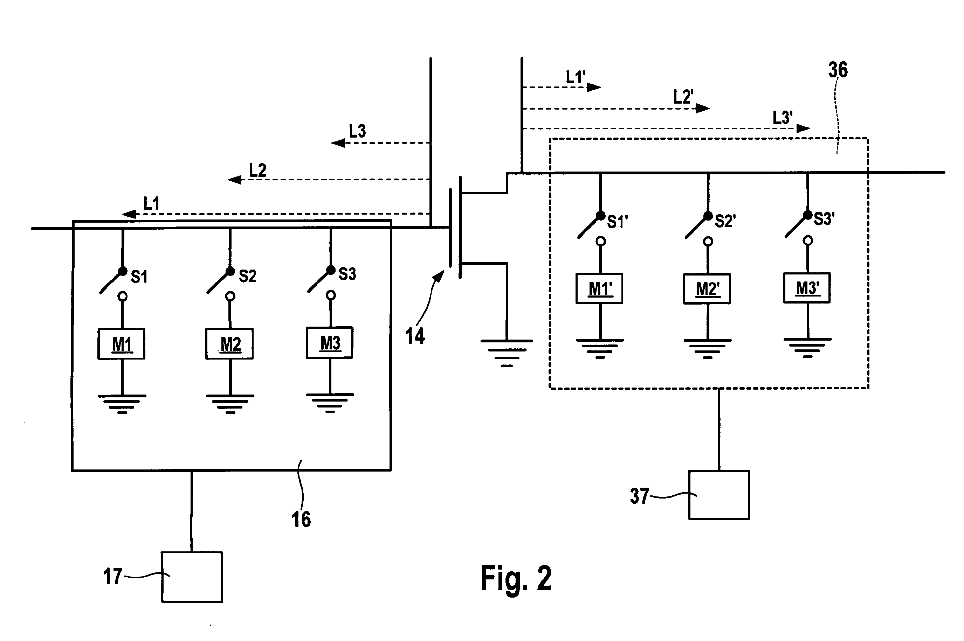

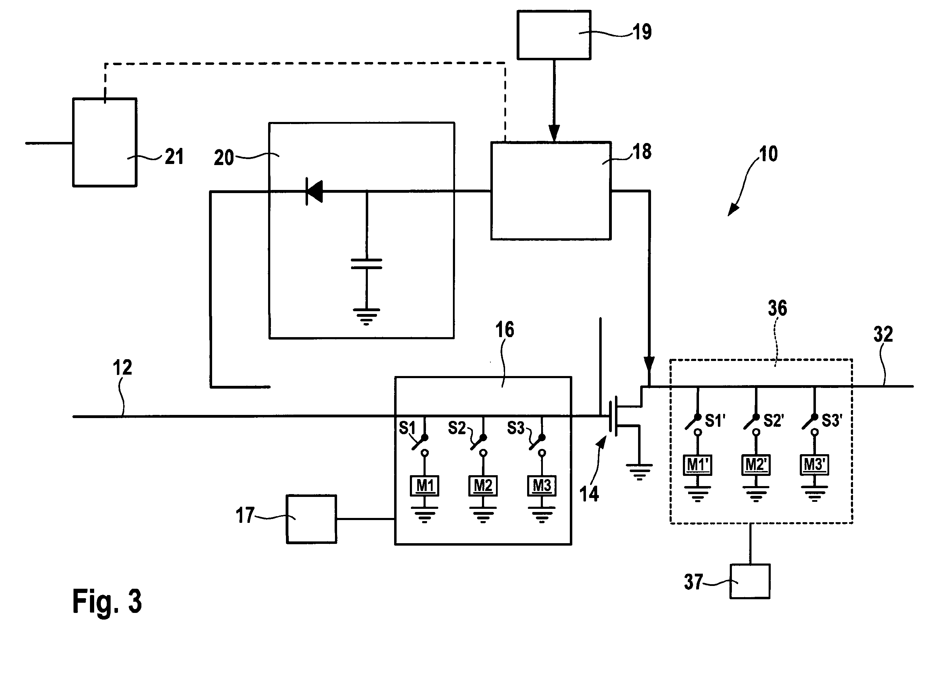

Optionally, e.g. in case of medium output power levels or availability of high power switching elements, the output matching network 36 of Fig. 1 can also be adaptive, as shown in Fig. 2 and Fig. 3. The output matching network 36 comprises sub networks interconnected in a parallel manner. The first sub network comprises a first matching element M1', e.g. a capacitor Cl' and a first switching element S1'. The first sub network is located at a distance L1' from the output of the power transistor 14. The second sub network comprises a second matching element M2', e.g. a capacitor C2', and a second switching element S2'. The second sub network is located at a distance L2' from the output of the power transistor 14. The third sub network comprises a third matching element M3', e.g. a capacitor C3', and a third switching element S3'. The third sub network is located at a distance L3' from the output of the power transistor 14. The adaptive matching of the output matching network is achieved by switching elements S1', S2', S3', e. g. PIN diodes and matching elements M1', M2', M3'. The control of the adaptation of the output matching is done over the matching control unit 37. The matching control unit 37 is for example used to switch the switches S1', S2', S3'. The first distance L1' from the transistor's 14 output is adapted to a first frequency band, to which the output matching network 36 is to be matched when the first switching element S1' is closed. The second distance L2' from the transistor's 14 output is adapted to a second frequency band, to which the output matching network 36 is to be matched when the second switching element S2' is closed. The third distance L3' from the transistor's 14 output is adapted to a third frequency band, to which the output matching network 36 is to be matched when the third switching element S3' is closed. If e. g. the first frequency band has to be covered, S1' is switched on, S2' and S3' are switched off and thus, M1' is active, resulting in an improved matching for the first frequency band. If the second frequency band is addressed, S2' is switched on, M2' is active and the remaining switches S1' and S3' are in off-state.

To achieve an even improved efficiency, the biasing of the amplifier transistor is dynamically adapted to an amplitude characteristic of the input signal. To achieve this goal, an Envelope Tracked Power Amplifier (ET-PA) principle can be used. Instead of providing a constant supply voltage to the amplifier transistor, as it is done for conventional class A amplifiers, the supply voltage and thus the 1 dB compression point, of the amplifier is adapted to the signal levels of the RF input signal, in order to improve efficiency. As the signal peaks of e. g. W-CDMA signals occur only sometimes, the conventional amplifier will most of the time be operated with a too high back-off from the 1 dB compression point. Higher efficiency can be achieved when the amplifier is operated close to the 1 dB compression point more often, preferably most of the time. This goal is achieved by adapting the supply voltage to each signal level. This is either done by detecting the input signal with the detection unit 20 or by tapping the digital signal, e. g. In-Phase and Quadrature (I&Q) components of the signal, directly at the digital transmitter part, via an suitable interface, and adapting the supply voltage of the amplifier transistor dynamically to changing signal amplitude levels. The adaptation of the supply voltage is done by bias control unit 18, which can for example be chosen to be a suitable high efficient modulator.

By combining the input matching network 16 and the amplifier transistor bias adaptation in the power amplifier 10, a multi-band multi-standard power amplifier can be realized, which has even improved efficiency.

In order to cover an as wide as possible frequency range, a suitable transistor technology as e. g. GaN can be chosen. GaN technology provides a high impedance level, and without band-limiting internal pre-matching, it is advantageous for multi-band or wideband applications. Since the 1 dB compression point adaptation of the amplifier transistor, e.g. by using the envelope tracked principle, is frequency agile, an improved efficiency for each selected frequency band can be achieved -the frequency band being selected by on- or off-switching the frequency related switches and matching capacitor as described above. The presented device presents a very advantageous and efficient combination of amplitude and frequency adaptation of a power amplifier since an improved multiband matching and thus improved amplifier performance, e. g. gain, power, etc. can be achieved by the adaptive in- and output matching and additionally, the included envelope tracking leads to an improved efficiency.

Many concepts, e. g. Standard Doherty, Class S, Class F etc., to enhance effieciency are more band limited than the proposed envelope tracking. Envelope tracking can be used over a wide frequency range and can therefore advantageously be combined with adaptive matching networks.

This invention realizes a multiband power amplifier with matching networks. To further increase effieciency and still have the advantage of wide band applicability, the input and optionally the output matching networks are adaptive. Matching itself is done for a narrow frequency band but is done adaptively, while the biasing using envelope tracking is frequency agile. The amplifier has the advantage of being applicable to a broad frequency range with narrow band adapted matching and therefore being efficient.

## Claims

1. Power amplifier (10) for amplifying a radio frequency input signal comprising
an input port (12),
an amplifier transistor (14), said amplifier transistor (14) being adaptable to an amplitude characteristic of said input signal,
an input matching network (16) placed in between said input port (12) and said amplifier transistor (14), said input matching network (16) being adaptable to a frequency characteristic of said input signal.

2. Power amplifier (10) according to claim 1,
**characterized by**
said input matching network (16) comprising a first sub network,
said first sub network comprising a first matching element (M1) and a first switching element (S1) at a first distance (L1) from the amplifier transistor (14), the first distance being adapted to a first frequency band to which said input matching network is adaptable.

3. Power amplifier (10) according to claim 2,
**characterized by**
said input matching network (16) being adaptable to a first frequency band by switching on said first switching element (S1), said switching being controlled by a matching control unit (17).

4. Power amplifier (10) according to claim 2,
**characterized by**
said input matching network (16) comprising a second sub network, said first sub network being connected to said first sub network in a serial manner,
said second sub network comprising a second matching element (M2) and a second switching element (S2) at a second distance (L2) from the amplifier transistor (14), the second distance being adapted to a second frequency band to which said input matching network is adaptable.

5. Power amplifier (10) according to claim 1,
further comprising
an output port (32) and
an output matching network (36) placed in between said output port (32) and said amplifier transistor (14), said output matching network (36) being adaptive to a frequency characteristic of said input signal.

6. Power amplifier (10) according to claim 1,
further comprising
a bias control unit (18) for generating an amplifier transistor (14) supply voltage for operating point adaptation of said amplifier transistor (14) to an amplitude characteristic of said radio frequency input signal.

7. Power amplifier (10) according to claim 6,
further comprising either a signal detection unit (20) placed in between said input port (12) and said bias control unit (18) for detecting said amplitude characteristic of said radio frequency input signal, or a digital interface (21) where the radio frequency signal can be directly tapped from the digital part of the transmitter in a digital manner and fed to the bias control unit (18).

8. Power amplifier (10) according to claim 7,
**characterized by**
said bias control unit (18) being adapted to dynamically adapt operating point said amplifier transistor (14) to said amplitude characteristic, either detected by said signal detection unit (20), or received from the digital transmitter part via said digital interface (21).

9. Transmitter for mobile communications comprising a power amplifier (10) according to claim 1.

10. Base station comprising a transmitter according to claim 9.

11. Method of operating a power amplifier (10) according to claim 1, comprising the steps of:
adapting the input matching network (16) to the frequency band of the input signal and
dynamically adapting the supply voltage of the amplifier transistor (14) to an amplitude signal characteristic of the input signal.
